# EUROPEAN PATENT SPECIFICATION

(11) **EP 2 279 535 B1**
(45) Date of publication and mention of the grant of the patent: **05.03.2014**
(21) Application number: 09733871.9
(22) Date of filing: 08.04.2009
(51) Int. Cl.: H01L 33/50

(54) **SEMICONDUCTOR LIGHT EMITTING DEVICES WITH SEPARATED WAVELENGTH CONVERSION MATERIALS AND METHODS OF FORMING THE SAME**
LICHTEMITTIERENDE HALBLEITERBAUELEMENTE MIT GETRENNTEN WELLENLÄNGENUMWANDLUNGSMATERIALIEN UND DEREN HERSTELLUNGSVERFAHREN
DISPOSITIFS À SEMI-CONDUCTEURS ÉMETTANTS DE LUMIÈRE AVEC MATÉRIAUX DE CONVERSION DE LONGUEUR D'ONDE SÉPARÉS ET LEURS PROCÉDÉS DE FABRICATION

(30) Priority: 25.04.2008 US 47824; 15.10.2008 US 251993
(43) Date of publication of application: 02.02.2011
(73) Proprietor: Cree, Inc., Durham, NC 27703 (US)
(72) Inventor: LETOQUIN, Ronan, P., Durham, NC 27713 (US); ANDREWS, Peter, Scott, Durham, NC 27712 (US)
(74) Representative: Boult Wade Tennant
(86) International application number: PCT/US2009/002193
(87) International publication number: WO 2009/131627

(56) References cited:
- EP-A- 1 566 848
- US-A1- 2006 061 259
- US-A1- 2006 202 105
- US-A1- 2006 226 759
- US-A1- 2007 210 326

## Description

### FIELD OF THE INVENTION

This invention relates to semiconductor light emitting devices and methods of fabricating semiconductor light emitting devices, and more particularly to semiconductor light emitting devices including wavelength conversion materials and methods of forming the same.

### BACKGROUND

Light emitting diodes and laser diodes are well known solid state electronic devices capable of generating light upon application of a sufficient voltage. Light emitting diodes and laser diodes may be generally referred to as light emitting devices ("LEDs"). Light emitting devices generally include a p-n junction formed in an epitaxial layer grown on a substrate such as sapphire, silicon, silicon carbide, gallium arsenide and the like. The wavelength distribution of the light generated by the LED generally depends on the material from which the p-n junction is fabricated and the structure of the thin epitaxial layers that make up the active region of the device.

Typically, an LED chip includes a substrate, an n-type epitaxial region formed on the substrate and a p-type epitaxial region formed on the n-type epitaxial region (or vice-versa). In order to facilitate the application of a voltage to the device, an anode ohmic contact is formed on a p-type region of the device (typically, an exposed p-type epitaxial layer) and a cathode ohmic contact is formed on an n-type region of the device (such as the substrate or an exposed n-type epitaxial layer).

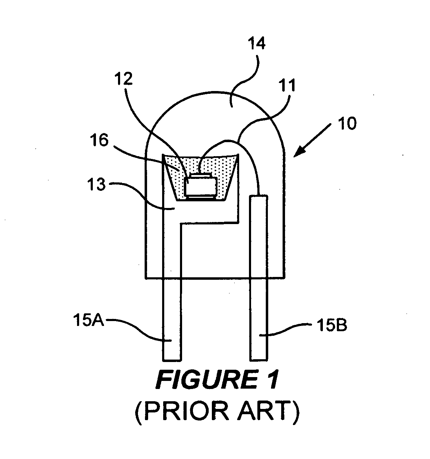

In order to use an LED chip in a circuit, it is known to enclose an LED chip in a package to provide environmental and/or mechanical protection, color selection, focusing and the like. An LED package also includes electrical leads, contacts or traces for electrically connecting the LED package to an external circuit. In a typical LED package 10 illustrated in Figure 1, an LED chip 12 is mounted on a reflective cup 13 by means of a solder bond or conductive epoxy. One or more wirebonds 11 connect the ohmic contacts of the LED chip 12 to leads 15A and/or 15B, which may be attached to or integral with the reflective cup 13. The reflective cup 13 may be filled with an encapsulant material 16 containing a wavelength conversion material such as phosphor particles. The entire assembly may then be encapsulated in a clear protective resin 14, which may be molded in the shape of a lens to collimate the light emitted from the LED chip 12. The term "phosphor" is used herein to refer to any materials that absorb light at one wavelength and re-emit light at a different wavelength, regardless of the delay between absorption and re-emission and regardless of the wavelengths involved. Accordingly, the term "phosphor" is used herein to refer to materials that are sometimes called fluorescent and/or phosphorescent. In general, phosphor particles absorb light having low wavelengths and re-emit light having longer wavelengths.

Typically, phosphor particles are randomly distributed within the matrix of encapsulant material. Some or all of the light emitted by the LED chip 12 at a first wavelength may be absorbed by the phosphor particles, which may responsively emit light at a second wavelength. For example, a blue-emitting chip may be encapsulated with an encapsulant matrix including a yellow-emitting phosphor. The combination of blue light (from the chip) with yellow light (from the phosphor) may produce a light that appears white. Some red-emitting phosphor particles may be included in the encapsulant matrix to improve the color rendering properties of the light, i.e. to make the light appear more "warm." Similarly, a UV-emitting chip may be encapsulated with an encapsulant material including phosphor particles that individually emit red, green and blue light upon excitation by UV light. The resulting light, which is a combination of red, green and blue light, may appear white and may have good color rendering properties.

However, rays of light emitted by the chip at different angles may follow different path lengths through the encapsulant material, which may result in the emission of different levels of light from the phosphor as a function of angle of emission. Because light may be emitted by the chip 12 in different intensities depending on the angle of emission, light emitted by the package 10 may have an uneven color distribution. Particle settling may also affect the color uniformity of the emitted light.

Furthermore, the volume of encapsulant material surrounding the LED chip 12 may tend to increase the effective size of the light source, which may increase the difficulty of designing secondary optics for the package.

Accordingly, some techniques for directly coating LED chips with phosphors have been proposed. For example, a phosphor coating technique is described in US Patent Publication No. 2006/0063289, assigned to the assignee of the present invention. Other techniques, such as electrophoretic deposition, have been proposed.
EP-1566848 relates to a wavelength converted semiconductor light emitting device with at least two wavelength converting materials, such as a phosphor.

### SUMMARY

The present invention provides a semiconductor device in accordance with claim 1 and a method of forming a semiconductor device in line with claim 3.

The first phosphor-containing region may include a first phosphor having a first excitation region and the second phosphor-containing region may include a second phosphor having a second excitation region. The first peak wavelength may be within the first and second excitation regions and the second peak wavelength may be outside the second excitation region. An emission spectrum of the second phosphor-containing region may be at least partially within the first excitation region.

The first peak wavelength may include a blue or UV wavelength. The first phosphor may include a red phosphor and the second phosphor may include a green/yellow phosphor.

The semiconductor device may further include a third phosphor-containing region on the second phosphor-containing region and remote from the first phosphor-containing region. The third phosphor-containing region may be configured to convert light emitted by the LED to light having a fourth peak wavelength that may be shorter than the second peak wavelength and shorter than the third peak wavelength.

The first peak wavelength may include a UV wavelength, the first phosphor may include a red phosphor, the second phosphor may include a green/yellow phosphor, and the third phosphor may include a blue phosphor.

The semiconductor device may further include an intermediate layer between the first phosphor-containing region and the second phosphor-containing region. The intermediate layer may include light scattering particles and/or may include a transflective layer.

The first peak wavelength may be between 400 and 500 nm, the second peak wavelength may be between 580 and 670 nm, and the third peak wavelength may be between 500 and 580 nm.

A surface of the second phosphor-containing region opposite the first phosphor-containing region may be textured for light extraction.

The first phosphor-containing region may include a plurality of discrete phosphor-containing regions on the LED structure, and the second phosphor-containing region may include a layer of phosphor-containing matrix material extending across the LED structure and on the plurality of discrete phosphor-containing regions remote from the LED. The phosphor-containing regions can include islands of phosphor-containing matrix material on the LED structure and/or recesses in the LED structure.

A semiconductor device according to some embodiments includes a semiconductor light emitting device (LED) configured to emit light having a first peak wavelength upon the application of a voltage thereto, and a plurality of first and second phosphor-containing regions on the LED that are configured to receive light emitted by the LED and to convert at least a portion of the received light to light having a longer wavelength than the first peak wavelength. The first and second phosphor-containing regions include discrete phosphor containing regions on a surface of the LED structure. The first phosphor-containing region may be configured to convert light emitted by the LED to light having a second peak wavelength and the second phosphor-containing region may be configured to convert light emitted by the LED to light having a third peak wavelength, shorter than the second peak wavelength.

The first and second discrete phosphor containing regions are spaced apart from one another on the surface of the LED structure.

The semiconductor device further includes an intermediate material between adjacent ones of the spaced apart first and second discrete phosphor containing regions. The intermediate material has a lower index of refraction than the second discrete phosphor containing regions. The intermediate material has a higher index of refraction than the first discrete phosphor containing regions.

The second discrete phosphor containing regions include a green/yellow phosphor and the first discrete phosphor containing regions include a red phosphor.

Some embodiments provide methods of forming a semiconductor device including an active region configured to emit light and a window layer configured to transmit the emitted light. The methods include forming a plurality of discrete phosphor-containing regions on an LED structure that is configured to emit light having a first peak wavelength in response to an electrical current, and forming an overlayer on the LED structure including the discrete phosphor-containing regions. The overlayer may include a phosphor that may be different than phosphor in the discrete phosphor-containing regions. The discrete phosphor-containing regions may be configured to convert light emitted by the LED to light having a second peak wavelength and the overlayer may be configured to convert light emitted by the LED to light having a third peak wavelength that is shorter than the second peak wavelength.

The discrete phosphor-containing regions may include a first phosphor having a first excitation region and the overlayer may include a second phosphor having a second excitation region. The first peak wavelength may be within the first and second excitation regions and the second peak wavelength may be outside the first excitation region. An emission spectrum of the second phosphor may be at least partially within the first excitation region.

The methods may further include texturing the overlayer to increase light extraction from the semiconductor device.

Forming the plurality of discrete phosphor-containing regions may include affixing a preformed silicone layer onto a semiconductor wafer, the preformed silicone layer including a plurality of recesses therein, and forming the discrete regions in the recesses.

Forming the plurality of discrete phosphor-containing regions may include depositing a layer of matrix material on the LED structure, selectively curing a portion of the matrix material, and removing an uncured portion of the matrix material to form islands of matrix material on the LED structure.

Selectively curing the matrix material may include forming a mask layer on the deposited layer of matrix material, patterning the mask layer to expose a portion of the matrix material, and curing the exposed portion of the matrix material.

Selectively curing the matrix material may include bringing a heated plate with ridges into proximity with the matrix material, thereby causing selected portions of the matrix material adjacent the heated ridges to cure.

The methods may further include forming a metal contact on the LED structure, and depositing the layer of matrix material may include depositing the layer of matrix material on the LED structure and the metal contact. The mask layer may cover at least a portion of the metal contact.

The methods may further include depositing a second matrix material on the LED structure including the islands of matrix material, forming a second mask on the second matrix material, patterning the second mask to expose at least a portion of the substrate other than a portion of the LED structure on which the islands of matrix material are formed, illuminating the exposed portion of the second matrix material with radiation having a wavelength sufficient to cure the exposed portion of the second matrix material, and removing an unexposed portion of the second matrix material to form second islands of matrix material on the LED structure.

The methods may further include forming an overlayer on the LED structure including the islands of matrix material. The overlayer may be formed on the LED structure before or after forming the first islands.

The LED structure may further include a semiconductor wafer including a plurality of dicing streets, and the mask layer may be formed at least over the plurality of dicing streets on the semiconductor wafer.

### BRIEF DESCRIPTION OF THE DRAWINGS

The accompanying drawings, which are included to provide a further understanding of the invention and are incorporated in and constitute a part of this application, illustrate certain embodiment(s) of the invention. In the drawings:

Figure 1 is a cross-sectional side view illustrating a conventional packaged light emitting device.

Figures 2A-2C are cross sectional views illustrating light emitting device structures according to exemplary devices outside the scope of the current invention.

Figure 3 is a graph illustrating exemplary emission spectra of an LED structure and various phosphor materials.

Figures 4A-4B are cross sectional views illustrating light emitting device structures according to some embodiments of the invention.

Figure 5 illustrates a close-up view of a first phosphor-containing region, an intermediate region, and a second phosphor-containing region that can be formed on a surface of a light emitting structure according to some embodiments.

Figures 6A-6D are cross sectional views illustrating light emitting device structures including discrete phosphor-bearing regions.

Figures 7A-7B are cross sectional views illustrating light emitting device structures including discrete phosphor-bearing regions according to further embodiments of the invention.

Figures 8A-8D are cross sectional views illustrating operations associated with the formation of light emitting diode structures including discrete phosphor-bearing regions, and light emitting diode structure so formed, according to some embodiments of the invention.

Figures 9A-9D are cross sectional views illustrating operations associated with the formation of light emitting diode structures including discrete phosphor-bearing regions, and light emitting diode structure so formed, according to further embodiments of the invention.

Figures 10A and 10B are cross sectional views illustrating light emitting diode structures including discrete phosphor-bearing regions and light scattering regions according to some embodiments of the invention.

Figures 11A and 11B are cross sectional views illustrating the dicing of light emitting diode structures including discrete phosphor-bearing regions according to some embodiments of the invention.

Figures 12A-12C are cross sectional views illustrating light emitting diode structures including discrete phosphor-bearing regions and light scattering regions according to some embodiments of the invention.

Figure 13 is a flowchart illustrating operations according to some embodiments of the invention.

Figures 14A-14C are cross sectional views illustrating deposition of phosphor particles on a light emitting device structure, and light emitting diode structure so formed, according to some embodiments of the invention.

Figures 15A-15C are cross sectional views illustrating deposition of phosphor particles on a light emitting device structure, and light emitting diode structure so formed, according to some embodiments of the invention.

### DETAILED DESCRIPTION OF EMBODIMENTS OF THE INVENTION

The present invention now will be described more fully with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete. In the drawings, the size and relative sizes of layers and regions may be exaggerated for clarity. Like numbers refer to like elements throughout.

It will be understood that when an element such as a layer, region or substrate is referred to as being "on" another element, it can be directly on the other element or intervening elements may also be present. It will be understood that if part of an element, such as a surface, is referred to as "inner," it is farther from the outside of the device than other parts of the element. Furthermore, relative terms such as "beneath" or "overlies" may be used herein to describe a relationship of one layer or region to another layer or region relative to a substrate or base layer as illustrated in the figures. It will be understood that these terms are intended to encompass different orientations of the device in addition to the orientation depicted in the figures. Finally, the term "directly" means that there are no intervening elements. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Embodiments of the invention are described herein with reference to cross-sectional, perspective, and/or plan view illustrations that are schematic illustrations of idealized embodiments of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, a region illustrated or described as a rectangle will, typically, have rounded or curved features due to normal manufacturing tolerances. Thus, the regions illustrated in the figures are schematic in nature and their shapes are not intended to illustrate the precise shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and this specification and will not be interpreted in an idealized or overly formal sense unless expressly so defined herein.

Various embodiments of the present invention for packaging a semiconductor light emitting device will be described herein. As used herein, the term semiconductor light emitting device may include a light emitting diode, laser diode and/or other semiconductor device which includes one or more semiconductor layers, which may include silicon, silicon carbide, gallium nitride and/or other semiconductor materials. A light emitting device may or may not include a substrate such as a sapphire, silicon, silicon carbide and/or another microelectronic substrates. A light emitting device may include one or more contact layers which may include metal and/or other conductive layers. In some embodiments, ultraviolet, blue and/or green light emitting diodes may be provided. Red and/or amber LEDs may also be provided. The design and fabrication of semiconductor light emitting devices are well known to those having skill in the art and need not be described in detail herein.

For example, the semiconductor light emitting device may be gallium nitride-based LEDs or lasers fabricated on a silicon carbide substrate such as those devices manufactured and sold by Cree, Inc. of Durham, North Carolina. The present invention may be suitable for use with LEDs and/or lasers as described in United States Patent Nos. 6,201,262; 6,187,606; 6,120,600; 5,912,477; 5,739,554; 5,631,190; 5,604,135; 5,523,589; 5,416,342; 5,393,993; 5,338,944; 5,210,051; 5,027,168; 5,027,168; 4,966,862 and/or 4,918,497, the disclosures of which are incorporated herein by reference as if set forth fully herein. Other suitable LEDs and/or lasers are described in published U.S. Patent Publication No. US 2003/0006418 A1 entitled Group III Nitride Based Light Emitting Diode Structures With a Quantum Well and Superlattice, Group III Nitride Based Quantum Well Structures and Group III Nitride Based Superlattice Structures, published January 9, 2003, as well as published U.S. Patent Publication No. US 2002/0123164 A1 entitled Light Emitting Diodes Including Modifications for Light Extraction and Manufacturing Methods Therefor. Furthermore, phosphor coated LEDs, such as those described in U.S. Patent Publication No. 2004/0056260 A1, entitled Phosphor-Coated Light Emitting Diodes Including Tapered Sidewalls and Fabrication Methods Therefor, the disclosure of which is incorporated by reference herein as if set forth fully, may also be suitable for use in embodiments of the present invention. The LEDs and/or lasers may be configured to operate such that light emission occurs through the substrate. In such embodiments, the substrate may be patterned so as to enhance light output of the devices as is described, for example, in the above-cited U.S. Patent Publication No. US 2002/0123164 A1.

As discussed above, some methods have been proposed for coating the surface of an LED chip with a phosphor, for example by evaporation and/or electrophoretic deposition. While these methods may be appropriate for the application of a single phosphor material in an LED chip, they may be unsuitable for the deposition of two or more wavelength conversion materials on a single chip.

The deposition of more than one phosphor material on an LED chip may be desirable under certain circumstances. For example, it may be desirable to include a red phosphor along with a yellow phosphor on a blue LED chip to improve the color rendering characteristics of the light produced by the chip. That is, it is known that white emitters including a blue light emitting device and a yellow phosphor may have poor color rendering characteristics due to the binary nature of the emitted light. In order to provide better color rendering, a red phosphor, that may also emit light in response to stimulation by light emitted by the blue LED chip, may provide a red light emission complement to the overall light emitted by the LED chip. The resulting light may have a warmer appearance that may give objects a more natural appearance when illuminated. However, the excitation curve of the red phosphor material may overlap with the emission curve of the yellow emitting phosphor, meaning that some light emitted by the yellow phosphor may be reabsorbed by the red phosphor, which may result in a loss of efficiency.

Some embodiments of the present invention provide methods and resulting LED structures that include discrete phosphor-containing regions on an outer layer of the LED structure. Different types of phosphors may be contained in separate ones of the discrete phosphor-containing regions, which may provide improved separation of different phosphors for warm white, UV/ RGB, and other phosphor applications. Further, phosphors of different colors may be arranged in a desired pattern on a chip to provide a desired emission pattern.

According to some embodiments of the invention, discrete phosphor-containing regions may be provided including phosphor particles suspended in a plurality of discrete matrices. According to some other embodiments of the invention, phosphor particles may be arranged on a surface of an LED structure at the particle level, and may not need to be provided in a matrix.

An LED structure generally includes an active region that includes a PN junction configured to inject minority carriers into one or more quantum well layers when a voltage is applied across the junction. When the minority carriers, which are typically electrons, recombine with holes in the quantum well layers, light may be emitted by the quantum well layers. Light generated in the active region may be extracted from the LED structure through one or more window layers.

In some embodiments, an LED chip may be formed using an epitaxial layer from which the substrate has been removed. In some embodiments, however, the substrate need not be removed from the LED chip, in which case the substrate may be substantially transparent to light, such as silicon carbide and/or sapphire.

If the LED structure includes a substrate, the substrate may be thinned, for example, by etching, mechanical lapping or grinding and polishing, to reduce the overall thickness of the structure. Techniques for thinning a substrate are described in U.S. Patent Publication No. 2005/0151138 entitled "Methods Of Processing Semiconductor Wafer Backsides Having Light Emitting Devices (LEDS) Thereon And LEDS So Formed," the disclosure of which is hereby incorporated by reference as if set forth fully herein. Furthermore, a substrate may be shaped or roughened using sawing, laser scribing or other techniques to introduce geometrical features such as angled sidewalls which may increase light extraction. The substrate may be further etched to improve light extraction using for example the etch process described in US. Patent Publication No. 2005/0215000 entitled "Etching Of Substrates Of Light Emitting Diodes," the disclosure of which is hereby incorporated by reference as if set forth fully herein.

Alternatively, the substrate may be remove entirely by substrate removal techniques such as the techniques taught in U.S. Patent Nos. 6,559,075, 6,071,795, 6,800,500 and/or 6,420,199 and/or U.S. Patent Publication No. 2002/0068201, the disclosures of which are hereby incorporated by reference as if set forth fully herein.

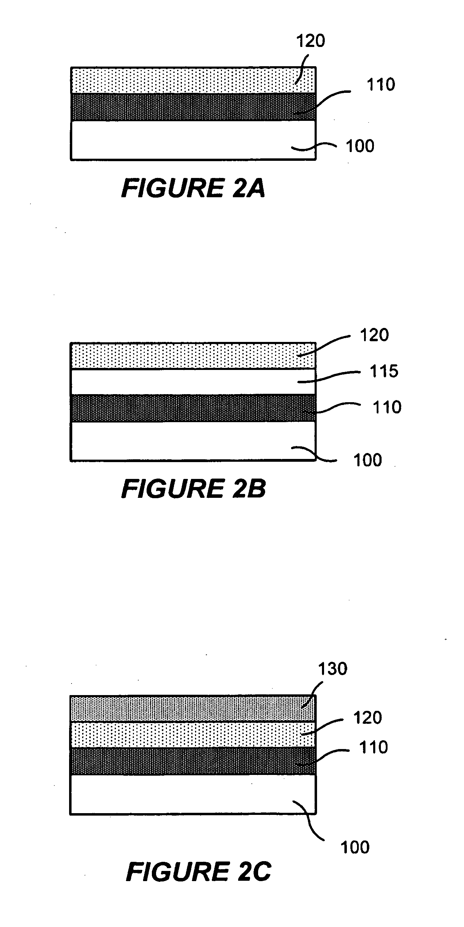

Some exemplary devices are illustrated in Figures 2A-2C, which illustrate LED structures 100 including various phosphor-containing regions thereon that are spaced apart vertically (i.e. spaced apart in a direction moving away from the face of the LED structure 100). For example, Figure 2A illustrates a structure including an LED structure 100 on which a first phosphor-containing region 110 is provided. A second phosphor-containing region 120 is provided on the first phosphor-containing region 110, so that the first phosphor-containing region 110 is between the LED structure 100 and the second phosphor-containing region 120. Light generated by the LED structure 100 passes through the first phosphor-containing region 110 and then through the second phosphor-containing region 120.

Figure 2B illustrates an LED structure 100 on which a first phosphor-containing region 110 is provided. An intermediate layer 115 is provided on the first phosphor-containing region 110. A second phosphor-containing region 120 is provided on the intermediate layer 115, so that the first phosphor-containing region 110 is between the LED structure 100 and the second phosphor-containing region 120, and the intermediate layer 115 is between the first phosphor-containing region 110 and the second phosphor-containing region 120. The intermediate layer 115 can be transparent and/or can include, for example, light scattering particles, such as TiO₂ and/or SiO₂ particles as described above. Light generated by the LED structure 100 passes through the first phosphor-containing region 110 and then through the second phosphor-containing region 120.

Figure 2C illustrates an LED structure 100 on which a first phosphor-containing region 110 is provided. A second phosphor-containing region 120 is provided on the first phosphor-containing region 110, so that the first phosphor-containing region 110 is between the LED structure 100 and the second phosphor-containing region 120. A third phosphor-containing region 130 is provided on the second phosphor-containing region 120, so that the second phosphor-containing region 120 is between the LED structure 100 and the third phosphor-containing region 130. Light generated by the LED structure 100 passes through the first phosphor-containing region 110, then through the second phosphor-containing region 120, and then through the third phosphor-containing region 130.

The LED structure 100 may be configured to generate light having a first peak wavelength, for example, in the blue or UV region of the visible spectrum. The first phosphor-containing region 110 is configured to convert light emitted by the LED structure 100 to light having a second peak wavelength that is longer than the first peak wavelength. That is, the first phosphor-containing region 110 is configured to absorb light emitted by the LED structure 100 and to responsively emit light having a longer wavelength. For example, the first phosphor-containing region 110 may be configured to emit red light in response to absorbing blue or UV light. The second phosphor-containing region 120 is configured to absorb light emitted by the LED structure 100 and to responsively emit light having a third peak wavelength that is longer than the first peak wavelength (of light emitted by the LED structure 100) but that is shorter than the second peak wavelength. For example, the second phosphor-containing region 120 may be configured to emit yellow, yellow-green or green light in response to absorbing blue or UV light from the LED structure 100. As used herein, the term green/yellow includes yellow, yellow-green and/or green.

Suitable red phosphors include Sr₂Si₅N₈:Eu²⁺, and CaAlSiN₃:Eu. Other red phosphors that can be used include phosphors from the Eu²+-SiAlON family of phosphors, as well as CaSiN₂:Ce³⁺, CaSiN₂:Eu²⁺ and/or phosphors from the (Ca,Si,Ba)SiO₄:Eu²⁺ (BOSE) family. Suitable yellow phosphors include Y₃Al₅O₁₂:Ce³⁺ (Ce:YAG), CaAlSiN₃:Ce³⁺, and phosphors from the Eu²⁺-SiAlON-family, and/or the BOSE family. Suitable green phosphors include phosphors from the BOSE family, as well as CaSi₂O₂N₂:Eu²⁺. The phosphor may also be doped at any suitable level to provide a desired wavelength of light output. In some embodiments, Ce and/or Eu may be doped into a phosphor at a dopant concentration in a range of about 0.1 % to about 20%. Suitable phosphors are available from numerous suppliers, including Mitsubishi Chemical Corporation, Tokyo, Japan, Leuchtstoffwerk Breitungen GmbH, Breitungen, Germany, and Intematix Company, Fremont, California.

The third phosphor-containing region 130 can be configured to absorb light emitted by the LED structure 100 and to responsively emit light having a fourth peak wavelength that is shorter than the third peak wavelength or the second peak wavelength. For example, referring to Figure 2C, in some embodiments the LED structure is configured to emit UV light, the first phosphor-containing region 110 includes a red phosphor, the second phosphor-containing region 120 includes a green phosphor, and the third phosphor-containing region 130 includes a blue phosphor.

In some variations, the second phosphor-containing region 120 may not be sensitive or responsive to light emitted by the first phosphor-containing region 110. That is, the light emitted by the first phosphor-containing region 110 may fall outside a excitation region of the phosphor in the second phosphor-containing region 120. Similarly, the third phosphor-containing region 130 may not be sensitive or responsive to light emitted by the first phosphor-containing region 110 or the second phosphor-containing region 120. That is, the light emitted by the first phosphor-containing region 110 and the second phosphor-containing region 120 may fall outside a excitation region of the phosphor in the third phosphor-containing region 130.

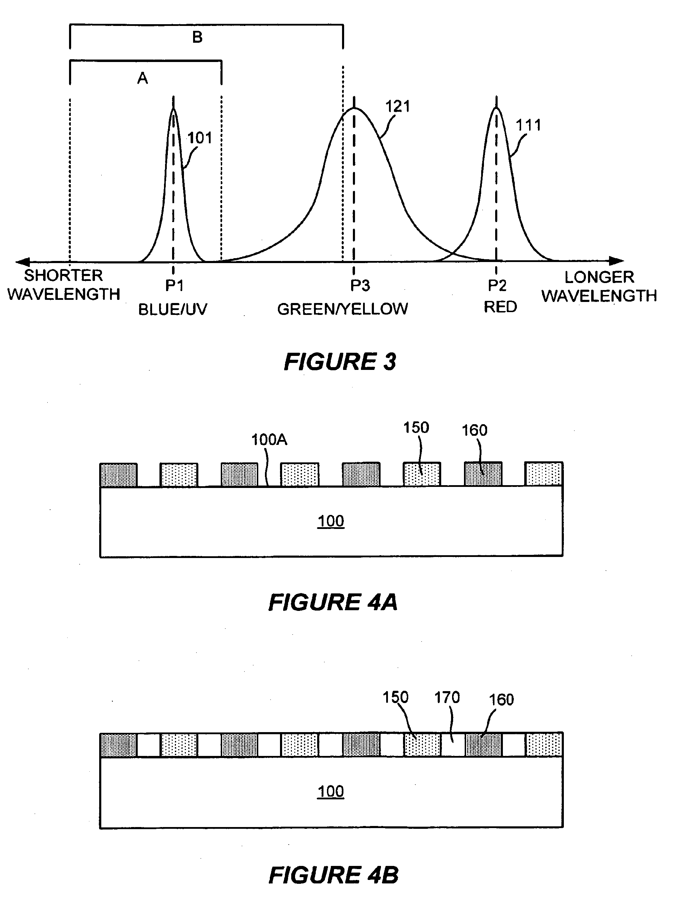

For example, Figure 3 is a graph that illustrates exemplary emission spectra of an LED structure, as well as the emission spectra of different types of phosphors. In the graph of Figure 3, shorter wavelengths are on the left, while longer wavelengths are on the right. Curve 101 represents an exemplary emission spectrum of a blue or UV LED structure 100. The emission spectrum 101 is centered around a peak wavelength P1 which falls in the blue or UV region of the visible spectrum. Curve 111 represents an exemplary emission spectrum of a phosphor in the first phosphor-containing region 110 in response to a light stimulus. The emission spectrum 111 is centered around a peak wavelength P2 which falls in the red region of the visible spectrum. Curve 121 represents an exemplary emission spectrum of a phosphor in the second phosphor-containing region 120 in response to a light stimulus. The emission spectrum 121 is centered around a peak wavelength P3 which falls in the green to yellow region of the visible spectrum.

It will be appreciated that the peak wavelength of an emission spectrum may be different from the dominant wavelength of the emission spectrum. Thus, the emission spectra need not be strictly symmetrical as illustrated. Moreover, the emission spectra may be broader or narrower than illustrated, and may have different or multiple peaks. For example, the peak of the emission spectrum 101 may be higher than either of the emission spectra 111 or 121.

The emission spectrum 101 of the LED structure 100 may fall within a excitation region A of the green/yellow phosphor that generates the emission spectrum 121. That is, the phosphor that emits light having the emission spectrum 121 (i.e. the green/yellow phosphor) can be responsive to light having a wavelength within the excitation region A. The emission spectrum 101 of the LED structure 100 may also fall within a excitation region B of the red phosphor that generates the emission spectrum 111. That is, the phosphor that emits light having the emission spectrum 111 can be responsive to light having a wavelength within the excitation region B. It will be appreciated that the excitation regions A and B illustrated in Figure 3 may not have sharp boundaries, but may fall off gradually at the edges thereof. As used herein, a wavelength of light is within an excitation region of a phosphor if a visually perceivable amount of light is emitted by the phosphor in response to stimulation by light at the wavelength that is generated by an LED structure or that is generated in response to light emitted by an LED structure.

In general, light is emitted by a phosphor when a photon having energy higher than a bandgap of the phosphor material passes through the phosphor and is absorbed. When the photon is absorbed, an electronic carrier in the phosphor is stimulated from a resting state to an excited state. When the electronic carrier decays back to a resting state, a photon can be emitted by the phosphor. However, the emitted photon may have an energy that is less than the energy of the absorbed photon. Thus, the emitted photon may have a wavelength that is longer than the absorbed photon.

As illustrated in Figure 3, the emission spectrum 121 of the green/yellow phosphor can at least partially fall within the excitation region B of the red phosphor. That is, some light that is emitted by the green/yellow phosphor can be re-absorbed by the red phosphor. Such re-absorption can lead to losses, as some energy is lost in every phosphor absorption/emission cycle. The re-absorption can also alter the color point of the combined light output by the structure.

However, as further illustrated in Figure 3, the emission spectrum 111 of the red phosphor is outside the excitation region A of the green/yellow phosphor. Thus, light emitted by the red phosphor may not substantially be absorbed and cause responsive emission by the green/yellow phosphor. It will be appreciated that there may be some negligible absorption of red light by the green/yellow phosphor that may be converted into heat instead of light.

To reduce losses from re-absorption of emitted photons and/or provide more consistent light output, some embodiments separate the second phosphor-containing region 120, corresponding to the green/yellow phosphor, apart from the first phosphor-containing region 110, corresponding to the red phosphor. For example, the second phosphor-containing region 120 can be placed on the first phosphor-containing region 110, so that light from the LED structure 100 passes through the red phosphor first. Un-absorbed blue/UV light from the LED structure 100 and red light generated in the first phosphor-containing region 110 then pass through the second phosphor-containing region 120. However, only the blue/UV light from the LED structure 100 may be absorbed by the phosphor in the second phosphor-containing region and cause emission of green/yellow light thereby.

Although some light generated in the second phosphor-containing region 120 can pass into the first phosphor-containing region 110 and be absorbed, such absorption/re-emission can be reduced according to some embodiments.

Referring to Figure 2B, a transflective coating can be provided as the intermediate layer 115 between the first phosphor-containing region 110 and the second phosphor-containing region 120 to reduce/prevent light generated in the second phosphor-containing region 120 from passing into the first phosphor-containing region 110, where it could be re-absorbed. A transflective coating may have a thickness of approximately 5-20 µm. The transflective coating may be, e.g., a nacreous pigment such as commercially available STR400 from Nippon Paper or a transflector material available from Teijin.

Figures 4A and 4B illustrate embodiments in which phosphor-containing regions are spaced apart laterally across a surface of an LED structure 100, rather than vertically. For example, as shown in Figure 4A, a plurality of first and second discrete phosphor-containing regions 150, 160 are provided on an LED structure 100, for example using the techniques described herein. The discrete phosphor-containing regions 150, 160 can include different types of phosphors and/or phosphors having different doping levels that are configured to emit different colors of light when stimulated by light within their respective excitation regions.

The first discrete phosphor-containing regions 150 are configured to emit longer wavelength light, such as red light, in response to blue or UV light emitted by the LED structure 100, while the second discrete phosphor-containing regions 160 are configured to emit shorter wavelength light, such as green/yellow light, in response to blue or UV light emitted by the LED structure 100.

As illustrated in Figures 4A and 4B, the first and second discrete phosphor-containing regions 150, 160 are disposed on a surface 100A of the LED structure 100 in an alternating manner. However, in some embodiments, two discrete phosphor-containing regions of the same type can be disposed adjacent one another and may abut or be spaced apart from one another as shown in Figure 4A.

As shown in Figure 4B, intermediate regions 170 can be disposed between adjacent ones of the discrete phosphor-containing regions 150, 160. The intermediate regions can be provided to reduce the possibility of light emitted by one discrete phosphor-containing region passing into another discrete phosphor-containing region and being reabsorbed therein. In exemplary devices, the intermediate regions 170 can have a lower index of refraction than either the first discrete phosphor-containing regions 150 or the second discrete phosphor-containing regions 160. In embodiments, the intermediate regions 170 have an index of refraction that is lower than the index of refraction of the second phosphor-containing regions 160 and that is higher than the index of refraction of the first phosphor-containing regions 150. Silicone polymer, which can have an index of refraction of about 1.3 to about 1.55 is a suitable material for forming the intermediate regions 170. The phosphors in the discrete phosphor-containing regions 150 and 160 can have an index of refraction of about 1.5 to about 2.5.

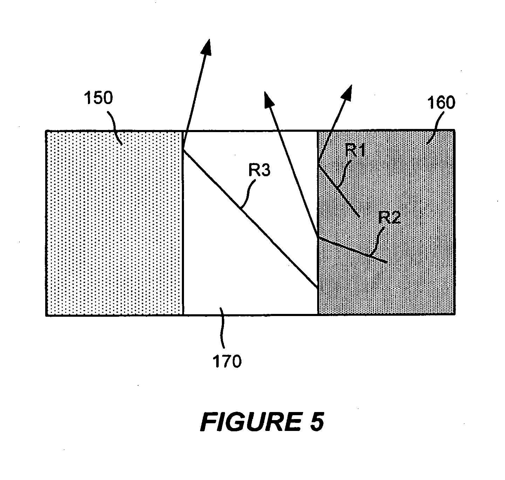

For example, Figure 5 illustrates a close-up cross-sectional view of a first phosphor-containing region 150, an intermediate region 170 and a second phosphor-containing region 160. The first phosphor-containing region 150 emits red light in response to light having a wavelength within its excitation region (see Figure 3). The second phosphor-containing region 160 emits green/yellow light in response to light having a wavelength within its excitation region. Furthermore, the green/yellow light emitted by the second phosphor-containing region 160 may be within the excitation region of the phosphor in the first phosphor-containing region 150 (i.e., the red phosphor). Thus, it may be desirable to reduce the amount of green/yellow light that passes into the first phosphor-containing region.

Because the intermediate region 170 has a lower index of refraction than the second phosphor-containing region 160, a ray of light generated within the second phosphor-containing region 160 that is directed toward the first phosphor-containing region can be reflected at the interface between the second phosphor-containing region 160 and the intermediate region 170 (such as ray R1) or redirected away from the first phosphor-containing region 150 (such as ray R2).

Moreover, because the intermediate region 170 has a higher index of refraction than the first phosphor-containing region 150, a ray of light directed into at the first phosphor-containing region 150 (such as ray R3) can be reflected at the interface between the first phosphor-containing region 150 and the intermediate region 170, or redirected so that it passes through less of the first phosphor-containing region 150 and thus has a lower chance of being absorbed therein.

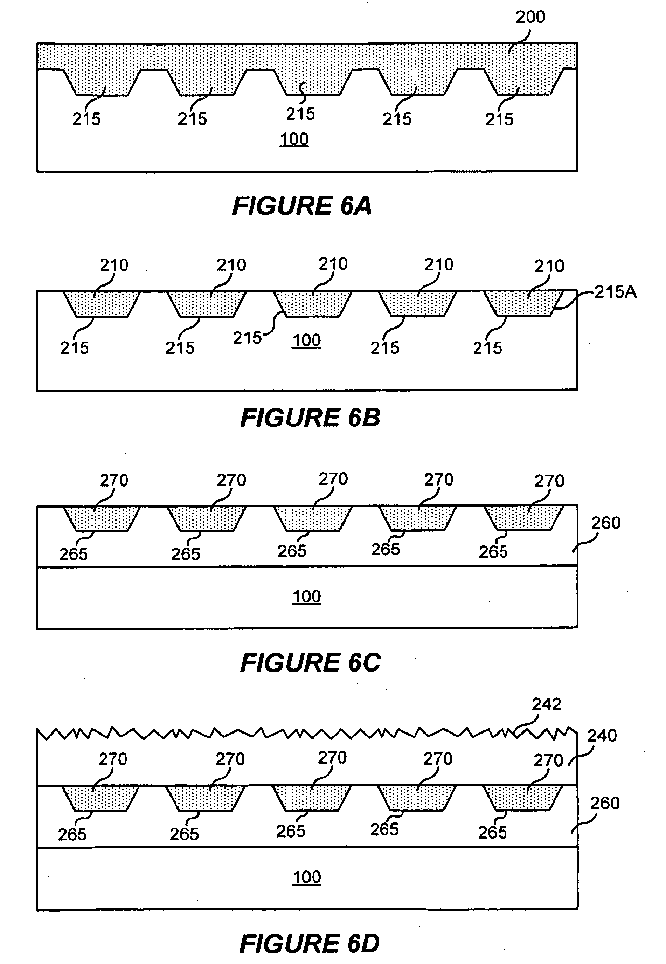

Further exemplary devices outside the scope of the invention are illustrated in Figures 6A and 6B, in which a plurality of recesses 215 are provided in a surface of an LED structure 100. The LED structure 100 may include an active region, one or more window layers, and/or a substrate as described above. The recesses 215 may be formed via etching, laser ablation, and or pattern transfer, as described above. A layer of a phosphor-containing matrix material 200 is provided on the surface of the LED structure 100 including the recesses 215. The phosphor-containing matrix material 200 may include, for example, a layer of silicone embedded with phosphor particles that maybe spin-coated onto the surface of the LED structure 100. The spin-coated layer of a phosphor-containing matrix material 200 may have a thickness of about 50 to about 95 µm. The phosphor-containing matrix material 200 may include one or more types of phosphor particles embedded therein.

Referring to Figure 6B, the layer of phosphor-containing matrix material 200 may be partially removed to reveal the surface of the LED structure 100 between the recesses 215, leaving a plurality of discrete phosphor-containing regions 210 in the recesses 215. The layer of phosphor-containing matrix material 200 may be partially removed, for example, by mechanically abrading or polishing away the layer of phosphor-containing matrix material 200 until the surface of the LED structure 100 is revealed.

Referring to Figure 6C, discrete phosphor-containing regions 270 may be provided in recesses 265 in a transparent layer 260 provided on the LED structure 100. The transparent layer 260 may include, for example, a photopatternable silicone material, and the recesses 265 may be provided in the layer 260 as described above. In some embodiments, the transparent layer 260 may include a preformed layer including recesses 265 that is applied to the LED structure 100. The preformed layer may include a photopatternable silicone material, such as WL-5150 photopatternable silicone material available from Dow Coming.

Referring to Figure 6D, an overlayer 140 may be provided on the LED structure 100 including the discrete phosphor-containing regions 270. The overlayer 140 may include, for example, a layer of silicone or other encapsulant material, and in some embodiments may include a phosphor-containing material. In some embodiments, the overlayer 140 may include a different phosphor material from the phosphor material contained in the discrete phosphor-containing regions 270. For example, the discrete phosphor-containing regions 270 can include a red phosphor, while the overlayer 140 may include a green/yellow phosphor, or vice versa.

The overlayer 240 may include other materials/structures that can change optical properties of light emitted by the LED structure 100. For example, the overlayer 240 can include optical diffusing/scattering particles. In some embodiments, a silicone gel can be used to form the overlayer 240 may include TiO₂ and/or SiO₂ particles having, for example, an average radius less than 1 µm embedded therein for reflectivity. In particular, crushed and/or fumed SiO₂ may be used, as may SiO₂ glass beads/balls, which may be engineered to a desired size. Accordingly, the overlayer 240 may help to improve the color uniformity of light emitted by the LED structure 100.

As illustrated in Figure 6D, the overlayer 240 can be textured and/or patterned to increase optical extraction from the device. Although a random texturing 242 is illustrated in Figure 6D, the texturing can be regular (e.g., periodic or otherwise patterned) in some embodiments if desired to produce a particular emission pattern.

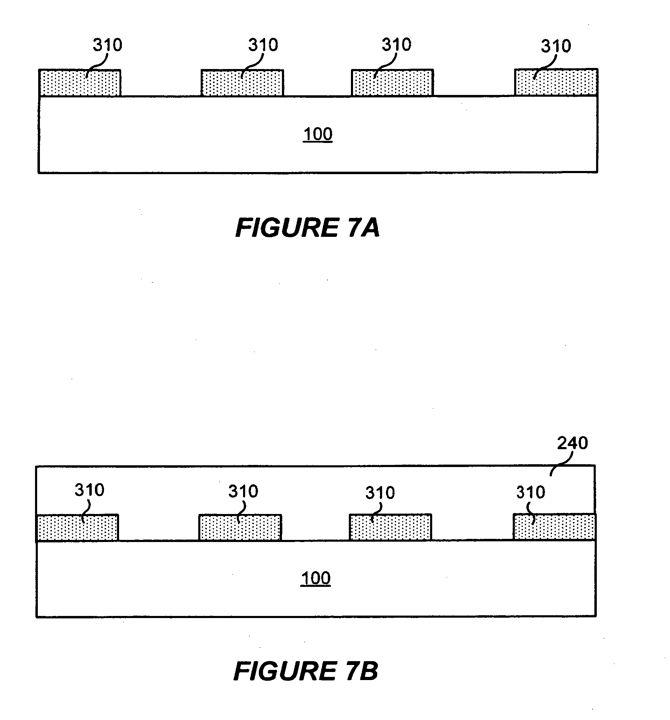

Referring to Figure 7A, according to some exemplary devices outside the scope of the invention, discrete phosphor-containing regions 310 may be provided on a surface of an LED structure 100, as described below. In particular, in some embodiments of the invention, discrete phosphor-containing regions 310 may be provided at regular and/or irregular intervals on the surface of the LED structure 100. Furthermore, multiple phosphor-containing regions 310 having different types of phosphors may be provided on the surface of the LED structure 100, as described in more detail below. The phosphor-containing regions 310 can abut one another and/or be spaced apart as shown in Figure 7A.

Referring to Figure 7B, an overlayer 240 may be provided on the LED structure 100 including the discrete phosphor-containing regions 310. The overlayer 240 may include, for example, a layer of silicone or other encapsulant material, and in some embodiments may include a phosphor-containing material. In some embodiments, the overlayer 240 may include a different phosphor material from the phosphor material contained in the discrete phosphor-containing regions 310. For example, the discrete phosphor-containing regions 310 can include a red phosphor, while the overlayer 240 may include a green/yellow phosphor, or vice versa.

The overlayer 240 may include other materials/structures that can change optical properties of light emitted by the LED structure 100. For example, the overlayer 240 can include optical diffusing/scattering particles and/or the overlayer 140 can be textured and/or patterned to increase optical extraction from the device.

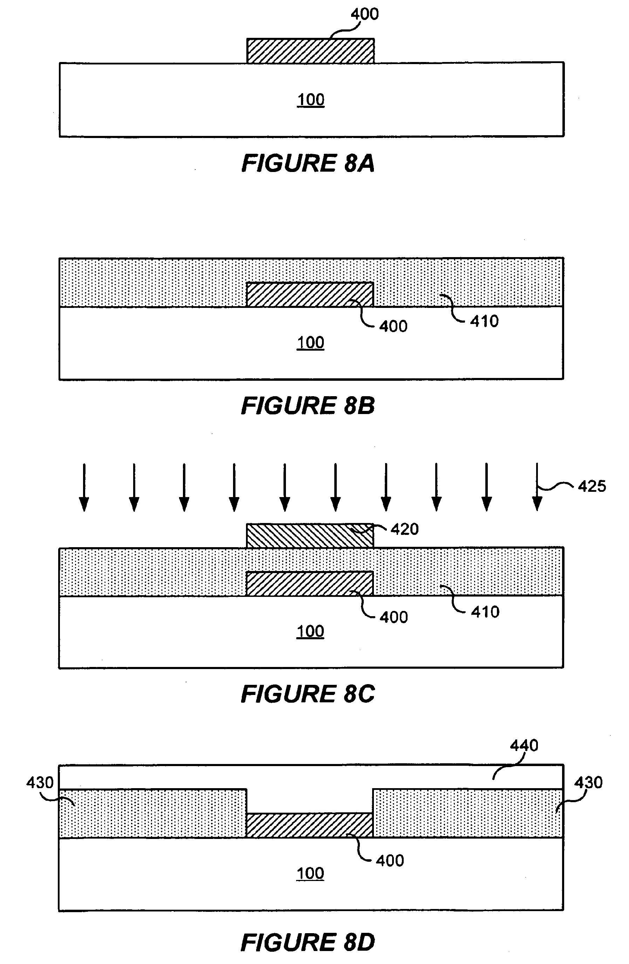

Referring now to Figures 8A-8D, the formation of discrete phosphor-containing regions on an LED structure, such as the discrete phosphor-containing regions 310 shown in Figures 7A-7B, is illustrated. In particular, a bond pad 400 is provided on a surface of an LED structure 100. While only a single bond pad 400 is shown in Figures 8A-8D, it will be appreciated that prior to dicing, an LED structure 100 may have many hundreds or even thousands of such bond pads 400 thereon. A layer 410 of a photopatternable phosphor-containing matrix material is deposited on the surface of the LED structure 100 and on the bond pad 400, as shown in Figure 8B. The photopatternable phosphor-containing matrix material 410 may include WL-5150 from Dow Coming, which may be spin-coated in liquid form onto the LED structure 100. The photopatternable phosphor-containing matrix material 410 may then be at least partially cured, for example by heating to a sufficient temperature to stabilize the layer 410. Next, a mask 420 is formed on the layer 410, as shown in Figure 8C. The mask 420 may cover regions on the LED structure 100 from which the matrix material 410 is to be removed. Some methods of forming phosphor-bearing materials are discussed in U.S. Patent Publication No. 2006/0061259 entitled "Semiconductor Light Emitting Devices Including Patternable Films Comprising Transparent Silicone And Phosphor, And Methods Of Manufacturing Same," which is assigned to the assignee of the present invention, the disclosure of which is incorporated herein by reference.

The LED structure 100 is then exposed to light 425 having a wavelength sufficient to cure the photopatternable phosphor-containing matrix material 410. The uncured portions of the photopatternable phosphor-containing matrix material 410 below the mask 420 are removed, leaving discrete phosphor-containing regions 430 on the surface of the LED structure 100, as shown in Figure 8D. An overlayer 440 may be provided on the LED structure 100 including the discrete phosphor-containing regions 430. The overlayer 440 may include, for example, a layer of silicone or other encapsulant material, and in some embodiments may include a phosphor-containing material. In some embodiments, the overlayer 440 may include a different phosphor material from the phosphor material contained in the discrete phosphor-containing regions 430. For example, the discrete phosphor-containing regions 430 can include a red phosphor, while the overlayer 440 may include a green/yellow phosphor, or vice versa.

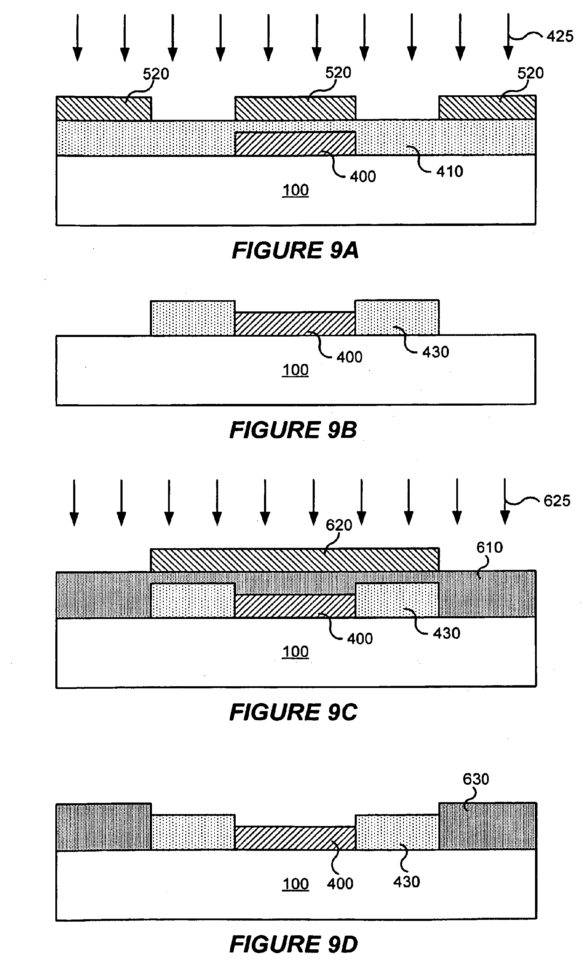

Methods of forming discrete phosphor-containing regions having different types of phosphors that are spaced laterally across a surface of an LED structure are illustrated in Figures 9A-9D, which are cross sectional diagrams illustrating operations and resulting devices according to some embodiments of the invention.

Referring to Figure 9A, a bond pad 400 is provided on a surface of an LED structure 100, and a first layer 410 of a photopatternable phosphor-containing matrix material is deposited on the surface of the LED structure 100 and on the bond pad 400. The first photopatternable phosphor-containing matrix material 410 may include therein a phosphor configured to emit light at a first wavelength in response to excitation by light emitted by an active region in the LED structure 100. The first photopatternable phosphor-containing matrix material 410 may be spin-coated in liquid form onto the LED structure 100 and then at least partially cured, for example by heating to a sufficient temperature to stabilize the layer 410. A first mask 520 is provided on the layer 410 and may cover regions on the LED structure 100 from which the matrix material 410 is to be removed. The LED structure 100 is then exposed to light 425 having a wavelength sufficient to cure the photopatternable phosphor-containing matrix material 410.

Referring to Figure 9B, the uncured portions of the photopatternable phosphor-containing matrix material 410 below the first mask 520 are removed, leaving first discrete phosphor-containing regions 430 on the surface of the LED structure 100.

Referring to Figure 9C, a second layer 610 of a photopatternable phosphor-containing matrix material is deposited on the surface of the LED structure 100 and on the bond pad 400 and the first discrete phosphor-containing regions 430 on the surface of the LED structure 100. The second photopatternable phosphor-containing matrix material 610 may include therein a phosphor configured to emit light at a second wavelength, different from the first wavelength, in response to excitation by light emitted by the active region in the LED structure 100.

The second photopatternable phosphor-containing matrix material 610 may be spin-coated in liquid form onto the LED structure 100 and then at least partially cured, for example by heating to a sufficient temperature to stabilize the layer 610. A second mask 620 is formed on the layer 610 and may cover regions on the LED structure 100 from which the second matrix material 610 is to be removed. The LED structure 100 is then exposed to light 625 having a wavelength sufficient to cure the second photopatternable phosphor-containing matrix material 610.

Referring to Figure 9D, the uncured portions of the photopatternable phosphor-containing matrix material 610 below the second mask 620 are removed, leaving second discrete phosphor-containing regions 630 on the surface of the LED structure 100 alongside the first discrete phosphor-containing regions 430.

The foregoing process may be repeated a desired number of times to form a plurality of discrete phosphor-containing regions 430, 630 on the surface of the LED structure 100. Moreover, depending on the shapes of the mask layers, the resulting discrete phosphor-containing regions provided on the LED structure 100 may have any desired pattern, such as dots, lines, triangles, hexagons, etc., with any desired periodicity. Further, the discrete phosphor-containing regions 430, 630 provided on the LED structure 100 may be in contact with adjacent phosphor-containing regions and/or may be separated from adjacent phosphor-containing regions. For example, in a warm white LED application, red and yellow phosphors may be physically separated to reduce reabsorption of yellow light by the red phosphors. The discrete phosphor-containing regions 430, 630 provided on the LED structure 100 can remain at different thicknesses and/or can be planarized.

In some embodiments, phosphor particles may not be added to the photopatternable matrix materials 410, 610 until after the photopatternable matrix materials 410, 610 have been deposited on the LED structure 100, or until after the discrete regions 430, 630 thereof have been formed on the LED structure 100. For example, in some embodiments, discrete regions 430 of a photopatternable matrix material such as silicone may be formed on an LED structure 100 as shown in Figure 9B. Phosphor particles may then be embedded in the discrete regions 430, for example, by dipping the wafer in a phosphor suspended solution to phosphor coat the discrete regions 430. In particular, the tacky nature of silicone may allow phosphor particles to stick to the discrete regions 430. Phosphor particles may also be blown onto the discrete regions 430.

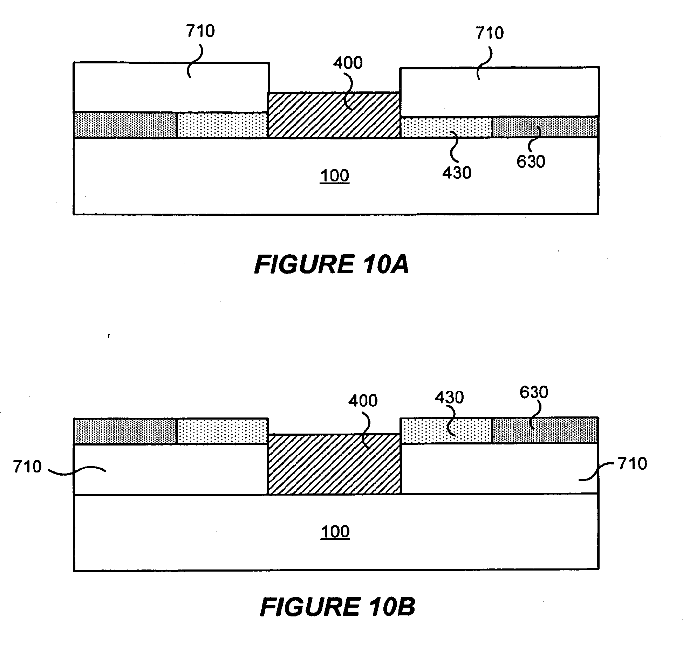

Further embodiments of the invention are illustrated in Figures 10A and 10B. As illustrated therein, a vertically separated layer 710 may be provided on the discrete phosphor-containing regions 430, 630 (Figure 10A), and/or the discrete phosphor-containing regions 430, 630 may be provided on a scattering layer 710 (Figure 10B). The vertically separated layer 710 may include a photopatternable silicone layer embedded with light scattering elements, and may be spin-coated on the surface of the LED structure 100 and cured before and/or after formation of the discrete phosphor-containing regions 430, 630. The vertically separated layer 710 can include a phosphor-containing material. In some embodiments, the vertically separated layer 710 may include a different phosphor material from the phosphor material contained in the discrete phosphor-containing regions 430, 630.

The silicone gel used to form the vertically separated layer 710 may include TiO₂ or SiO₂ particles having, for example, an average radius less than 1 µm embedded therein for reflectivity. In particular, crushed and/or fumed SiO₂ may be used, as may SiO₂ glass beads/balls, which may be engineered to a desired size. The vertically separated layer 710 may help to improve the color uniformity of light emitted by the LED structure 100.

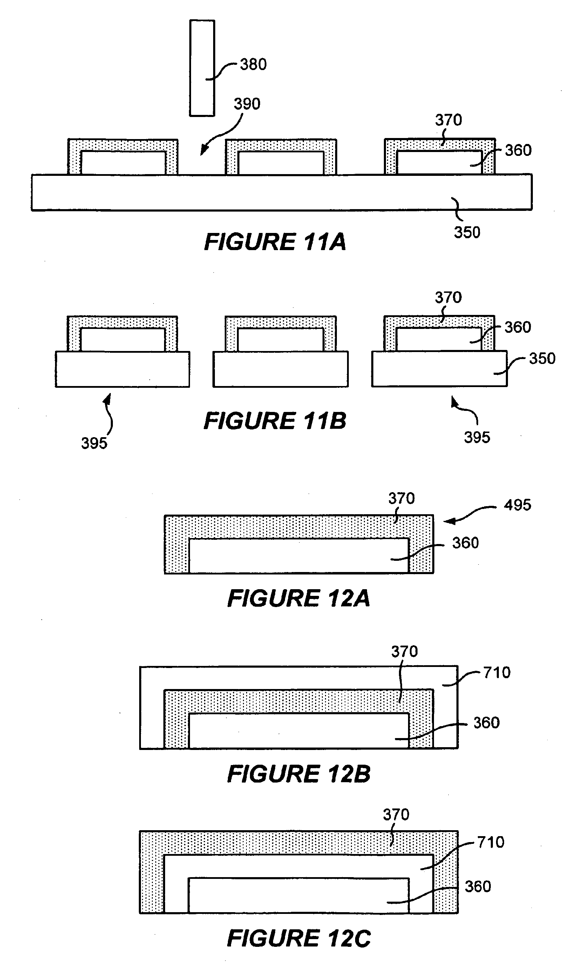

Some further exemplary devices outside the scope of the invention are illustrated in Figures 11A and 11B. As shown therein, a wafer 350 includes a plurality of light emitting devices 360 thereon. The wafer 350 may be a growth wafer on which the light emitting devices are grown and/or may be a carrier wafer on which the light emitting devices have been mounted. The light emitting devices 360 include a plurality of discrete phosphor-containing regions thereon, which are illustrated schematically by the layers 370 on the light emitting devices 360. Regions 390 between the light emitting devices 360, which may correspond to saw streets, may not include the discrete phosphor-containing regions 370. Accordingly, when wafer is diced, for example using a dicing saw 380, the dicing saw 380 may not cut through the phosphor-containing regions 370. Since the phosphor particles in the phosphor-containing regions 370 are abrasive, it may cause undue wear to the blade of the dicing saw 380 to cut through phosphor-containing regions such as the discrete phosphor-containing regions 370.

Referring to Figure 11B, the wafer 350 may be diced to provide individual light emitting diodes 395 including discrete phosphor-containing regions 370 thereon.

Although the substrate 350 is shown as remaining on the diodes 395 in Figure 11B, it will be appreciated that the substrate 350 may be removed from the light emitting devices 360. For example, referring to Figure 12A, a light emitting diode 495 including a light emitting device 360 that has been removed from a substrate is illustrated. As shown in Figure 12B, a vertically separated layer 710 as described above may be provided on the discrete phosphor-containing regions 370, such that the discrete phosphor-containing regions 370 are between the vertically separated layer 710 and the light emitting device 360. Or, as illustrated in Figure 12C, the discrete phosphor-containing regions 370 may be provided on a vertically separated layer 710, such that the vertically separated layer 710 is between the discrete phosphor-containing regions 370 and the light emitting device 360.

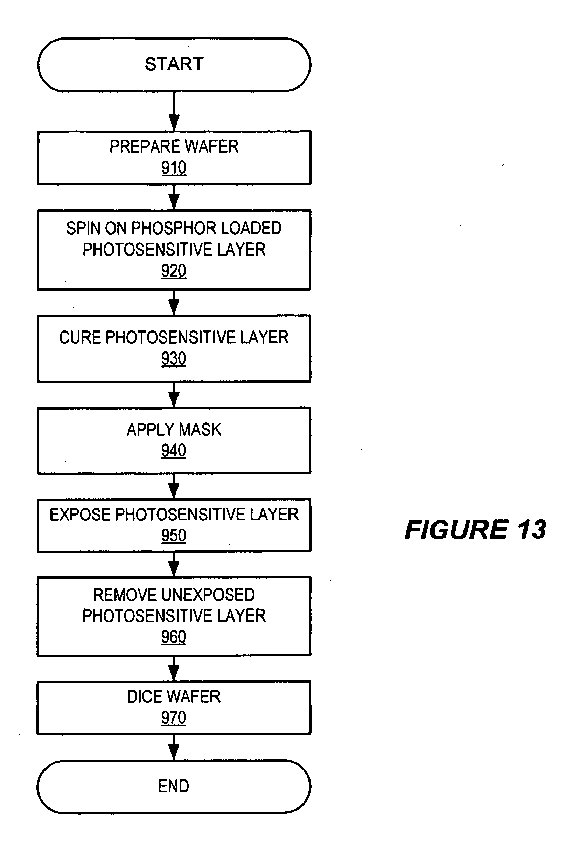

Operations according to some embodiments of the invention are illustrated in Figure 13. Referring to Figures 8A-8D and Figure 13, an LED structure 100 is prepared, for example, by forming an active region and one or more window layers thereon (Block 910). The LED structure 100 may also be mounted and cleaned in preparation for forming discrete phosphor-containing regions thereon. A phosphor loaded photosensitive layer 410, such as a photopatternable silicone, is spin-coated onto the LED structure 100 (Block 920), and the photosensitive layer 410 is at least partially cured, for example, to stabilize the layer (Block 930). The phosphor-containing photosensitive layer 410 includes therein phosphor particles configured to convert light emitted by the active region in the LED structure 100 to a different wavelength.

A mask 420 is applied to the stabilized phosphor loaded photosensitive layer 410 (Block 940). The mask 420 is patterned to expose portions of the LED structure 100 on which discrete phosphor-containing regions are to be formed. Next, the LED structure 100 including the phosphor loaded photosensitive layer 410 is exposed with light having a wavelength sufficient to cure the phosphor loaded photosensitive layer 410 (Block 950). The mask 420 and the unexposed portions of the phosphor loaded photosensitive layer 410 are then removed (Block 960) to provide discrete phosphor-containing regions 430. The LED structure 100 is then diced to provide individual semiconductor light emitting devices including discrete phosphor-containing regions 430 (Block 970).

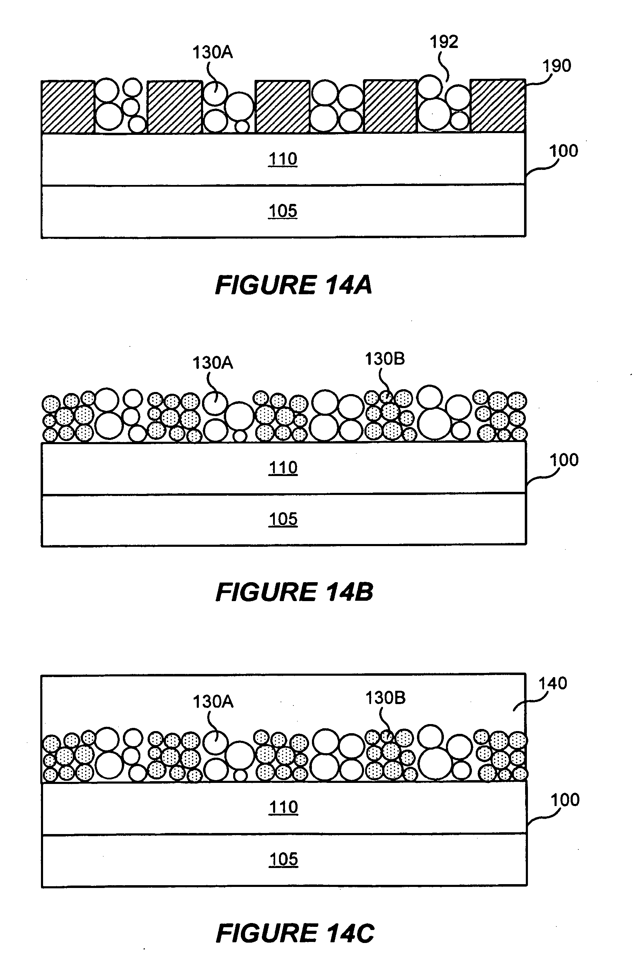

Other methods may be used to apply the phosphor particles 130 to an LED structure 100 in an organized manner. For example, referring to Figure 14A, a micro-screen 190 can be applied to an LED structure 100 to at wafer level (or die level). The micro-screen 190 can include a material such as a fine filament woven fabric or other material used for filtering particulate materials. Micro-screen filters are well known in the material filtering art. The micro-screen 190 includes openings 192 therein that expose the LED structure 100 and that have a width selected to permit a desired size of phosphor particle 130A to contact the LED structure therethrough. The phosphor particles 130A may be deposited, and then the screen may be removed, leaving the phosphor particles on the LED structure in a desired pattern. Additional particles 130B may then be deposited, and may organize in the spaces previously occupied by the screen, as shown in Figure 14B. The additional phosphor particles 130B may have at least one optical property different from the phosphor particles 130A. For example, the additional phosphor particles 130B may convert incident light to a different color than the phosphor particles 130A, and/or the additional phosphor particles 130B may scatter incident light in a different pattern than the phosphor particles 130A. The phosphor particles 130A and the phosphor particles 130B may each have a diameter in the range of about 1 µm to about 20 µm.

Referring to Figure 14C, an overlayer 140 may be provided on the LED structure 100 including the organized phosphor particles 130A, 130B. The overlayer 140 may include, for example, a layer of silicone or other encapsulant material, and in some embodiments may include a phosphor-containing material. In some embodiments, the overlayer 140 may include a different phosphor material from the phosphor material contained in the organized phosphor particles 130A, 130B. The overlayer 140 may include other materials/structures that can change optical properties of light emitted by the LED structure 100. For example, the overlayer 140 can include optical diffusing/scattering particles and/or the overlayer 140 can be textured and/or patterned to increase optical extraction from the device.

Some silicones can be formulated to be very tacky after curing. Such materials are typically referred to as soft gels. This property can be used to advantage by adhering a tacky silicone on a surface and embedding phosphor from a micro-screen loaded with phosphor into the silicone. In other embodiments, a harder silicone with low tack may be used so that phosphor particles can move across a surface.

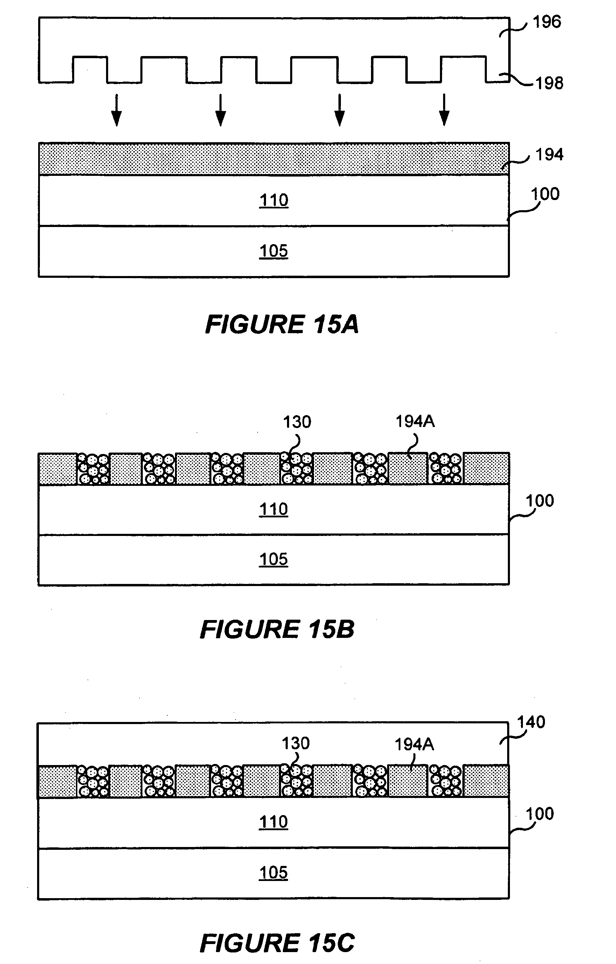

In some embodiments, a transparent layer can be provided by pressing into it in a partial cure state for example, then finishing cure, to form particle organizing layer. For example, referring to Figures 15A and 15B, a transparent silicone layer 194 may be provided on an LED structure 100. The silicone layer 194 may or may not include embedded phosphors 130A.

Portions of the transparent layer 194 of, for example, a matrix material such as silicone, may be selectively cured. For example, a heated plate 196 with ridges 198 may be brought into proximity with the silicone layer 194, causing selected portions 194A of the transparent layer 194 adjacent the heated ridges to cure. The remaining uncured portions of the transparent layer 194 are removed, leaving a cured phosphor-organizing layer including cured portions 194A. Additional phosphor particles 130 may be deposited in the space previously occupied by the uncured portions of the transparent layer 194.

Referring to Figure 15C, an overlayer 140 may be provided on the LED structure 100 including the phosphor particles 130 and cured portions 194A. The overlayer 140 may include, for example, a layer of silicone or other encapsulant material, and in some embodiments may include a phosphor-containing material. In some embodiments, the overlayer 140 may include a different phosphor material from the phosphor material contained in the phosphor particles 130. The overlayer 140 may include other materials/structures that can change optical properties of light emitted by the LED structure 100. For example, the overlayer 140 can include optical diffusing/scattering particles and/or the overlayer 140 can be textured and/or patterned to increase optical extraction from the device.

While particular embodiments are described herein, various combinations and subcombinations of the structures described herein are contemplated and will be apparent to a skilled person having knowledge of this disclosure.

The foregoing is illustrative of the present invention and is not to be construed as limiting thereof. Although a few exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. Therefore, it is to be understood that the foregoing is illustrative of the present invention and is not to be construed as limited to the specific embodiments disclosed, and that modifications to the disclosed embodiments, as well as other embodiments, are intended to be included within the scope of the appended claims. The invention is defined by the following claims.

## Claims

1. A semiconductor device, comprising:
a semiconductor light emitting device (LED)(100) configured to emit light having a first peak wavelength upon the application of a voltage thereto; and
a plurality of first and second phosphor-containing regions (110,120,130,150,160,210,270,310,430,630,370) on the LED that are configured to receive light emitted by the LED and to convert at least a portion of the received light to light having a longer wavelength than the first peak wavelength;
wherein the first and second phosphor-containing regions each comprise discrete phosphor containing regions on a surface of the LED structure;
wherein the first phosphor-containing region (110,150) is configured to convert light emitted by the LED to light having a second peak wavelength and the second phosphor-containing region (120,130,160) is configured to convert light emitted by the LED to light having a third peak wavelength, shorter than the second peak wavelength, and
wherein the first and second discrete phosphor containing regions are spaced apart from one another on the surface of the LED structure;
the device further comprising an intermediate material (115,170) between adjacent ones of the spaced apart first and second discrete phosphor containing regions, **characterised in that** the intermediate material has a lower index of refraction than the second discrete phosphor containing regions, and the intermediate material has a higher index of refraction than the first discrete phosphor containing regions.

2. The semiconductor device of Claim 1, wherein the second discrete phosphor containing regions comprise a green/yellow phosphor and the first discrete phosphor containing regions comprise a red phosphor.

3. A method of forming a semiconductor device, comprising:
providing a semiconductor light emitting device (LED) (100) configured to emit light having a first peak wavelength upon the application of a voltage thereto; and
forming a plurality of first and second phosphor-containing regions (110, 120, 130, 150, 160, 210, 270, 310, 430, 630, 370) on the LED that are configured to receive light emitted by the LED and to convert at least a portion of the received light to light having a longer wavelength than the first peak wavelength, wherein the first and second phosphor-containing regions each comprise discrete phosphor containing regions on a surface of the LED structure wherein the first phosphor-containing region is configured to convert light emitted by the LED to light having a second peak wavelength and the second phosphor-containing region is configured to convert light emitted by LED to light having a third peak wavelength, shorter than the second peak wavelength, and wherein the first and second discrete phosphor containing regions are spaced apart from one another on the surface of the LED structure; and
forming an intermediate material (115,170) between adjacent ones of the spaced apart first and second discrete phosphor containing regions, **characterised in that** the intermediate material has a lower index of refraction than the second discrete phosphor containing regions, and the intermediate material has a higher index of refraction than the first discrete phosphor containing regions.

4. The method of Claim 3, wherein the second discrete phosphor containing regions comprise a green/yellow phosphor and the first discrete phosphor containing regions comprise a red phosphor.

## Patentansprüche

1. Halbleitervorrichtung, umfassend:
eine Halbleiter-Lichtemissionsvorrichtung (LED) (100), welche dafür eingerichtet ist, um bei Anwendung einer Spannung daran Licht zu emittieren, welches eine erste Peakwellenlänge aufweist; und
eine Mehrzahl von ersten und zweiten Phosphor-enthaltenden Regionen (110, 120, 130, 150, 160, 210, 270, 310, 430, 630, 370) auf der LED, welche dafür eingerichtet sind, um durch die LED emittiertes Licht zu empfangen und mindestens einen Teil des empfangen Lichts in Licht zu konvertieren, welches eine längere Wellenlänge als die erste Peakwellenlänge aufweist;
wobei die ersten und zweiten Phosphor-enthaltenden Regionen jeweils diskrete Phosphor enthaltende Regionen auf einer Oberfläche der LED-Struktur umfassen;
wobei die erste Phosphor-enthaltende Region (110, 150) dafür eingerichtet ist, von der LED emittiertes Licht in Licht zu konvertieren, welches eine zweite Peakwellenlänge aufweist und die zweite Phosphor-enthaltende Region (120, 130, 160) dafür eingerichtet ist, von der LED emittiertes Licht in Licht zu konvertieren, welches eine dritte Peakwellenlänge aufweist, welche kürzer als die zweite Peakwellenlänge ist, und
wobei die ersten und zweiten diskreten Phosphor enthaltenden Regionen voneinander auf der Oberfläche der LED-Struktur beabstandet sind;
wobei die Vorrichtung ferner ein Zwischenmaterial (115, 170) zwischen benachbarten aus den voneinander beabstandeten ersten und zweiten diskreten Phosphor enthaltenden Regionen umfasst, **dadurch gekennzeichnet,**
**dass** das Zwischenmaterial einen niedrigeren Brechungsindex als die zweiten diskreten Phosphor enthaltenden Regionen aufweist, und das Zwischenmaterial einen höheren Brechungsindex als die ersten diskreten Phosphor enthaltenden Regionen aufweist.

2. Halbleitervorrichtung nach Anspruch 1, wobei die zweiten diskreten Phosphor enthaltenden Regionen einen grünen/gelben Phosphor umfassen und die ersten diskreten Phosphor enthaltenden Regionen einen roten Phosphor umfassen.

3. Verfahren zum Bilden einer Halbleitervorrichtung, umfassend:
Bereitstellen einer Halbleiter-Lichtemissionsvorrichtung (LED) (100), welche dafür eingerichtet ist, um bei Anwendung einer Spannung daran Licht zu emittieren, welches eine erste Peakwellenlänge aufweist; und
Bilden einer Mehrzahl von ersten und zweiten Phosphorenthaltenen Regionen (110, 120, 130, 150, 160, 210, 270, 310, 430, 630, 370) auf der LED, welche dafür eingerichtet sind, um durch die LED emittiertes Licht zu empfangen und mindestens einen Teil des empfangen Lichts in Licht zu konvertieren, welches eine längere Wellenlänge als die erste Peakwellenlänge aufweist, wobei die ersten und zweiten Phosphor-enthaltenden Regionen jeweils diskrete Phosphor enthaltende Regionen auf einer Oberfläche der LED-Struktur umfassen, wobei die erste Phosphor-enthaltende Region dafür eingerichtet ist, von der LED emittiertes Licht in Licht zu konvertieren, welches eine zweite Peakwellenlänge aufweist und die zweite Phosphor-enthaltende Region dafür eingerichtet ist, von der LED emittiertes Licht in Licht zu konvertieren, welches eine dritte Peakwellenlänge aufweist, welche kürzer als die zweite Peakwellenlänge ist, und wobei die ersten und zweiten diskreten Phosphor enthaltenden Regionen voneinander auf der Oberfläche der LED-Struktur beabstandet sind; und
Bilden eines Zwischenmaterials (115, 170) zwischen benachbarten aus den voneinander beabstandeten ersten und zweiten diskreten Phosphor enthaltenden Regionen, **dadurch gekennzeichnet,**
**dass** das Zwischenmaterial einen niedrigeren Brechungsindex als die zweiten diskreten Phosphor enthaltenden Regionen aufweist, und das Zwischenmaterial einen höheren Brechungsindex als die ersten diskreten Phosphor enthaltenden Regionen aufweist.

4. Verfahren nach Anspruch 3, wobei die zweiten diskreten Phosphor enthaltenden Regionen einen grünen/gelben Phosphor umfassen und die ersten diskreten Phosphor enthaltenden Regionen einen roten Phosphor umfassen.

## Revendications

1. Dispositif à semi-conducteur, comprenant :
un dispositif électroluminescent à semi-conducteur (LED) (100) configuré pour émettre une lumière ayant une première longueur d'onde de crête lors de l'application d'une tension à celui-ci ; et
une pluralité de premières et deuxièmes zones contenant un luminophore (110, 120, 130, 150, 160, 210, 270, 310, 430, 630, 370) sur le dispositif LED qui sont configurées pour recevoir la lumière émise par le dispositif LED et pour convertir au moins une partie de la lumière reçue en une lumière ayant une longueur d'onde plus longue que la première longueur d'onde de crête ;
dans lequel les premières et deuxièmes zones contenant un luminophore comprennent chacune des zones discrètes contenant un luminophore sur une surface de la structure LED ;
dans lequel la première zone contenant un luminophore (110, 150) est configurée pour convertir la lumière émise par le dispositif LED en une lumière ayant une deuxième longueur d'onde de crête et la deuxième zone contenant un luminophore (120, 130, 160) est configurée pour convertir la lumière émise par le dispositif LED en une lumière ayant une troisième longueur d'onde de crête, plus courte que la deuxième longueur d'onde de crête, et
dans lequel les premières et deuxièmes zones discrètes contenant un luminophore sont espacées les unes des autres sur la surface de la structure LED ;
le dispositif comprenant en outre un matériau intermédiaire (115, 170) entre des zones adjacentes parmi les premières et deuxièmes zones discrètes espacées contenant un luminophore,
**caractérisé en ce que** le matériau intermédiaire a un indice de réfraction inférieur à celui des deuxièmes zones discrètes contenant un luminophore, et le matériau intermédiaire a un indice de réfraction supérieur à celui des premières zones discrètes contenant un luminophore.

2. Dispositif à semi-conducteur de la revendication 1, dans lequel les deuxièmes zones discrètes contenant un luminophore comprennent un luminophore vert/jaune et les premières zones discrètes contenant un luminophore comprennent un luminophore rouge.

3. Procédé de formation d'un dispositif à semi-conducteur, comprenant le fait :
de fournir un dispositif électroluminescent à semi-conducteur (LED) (100) configuré pour émettre une lumière ayant une première longueur d'onde de crête lors de l'application d'une tension à celui-ci ; et
de former une pluralité de premières et deuxièmes zones contenant un luminophore (110, 120, 130, 150, 160, 210, 270, 310, 430, 630, 370) sur le dispositif LED qui sont configurées pour recevoir la lumière émise par le dispositif LED et pour convertir au moins une partie de la lumière reçue en une lumière ayant une longueur d'onde plus longue que la première longueur d'onde de crête, où les premières et deuxièmes zones contenant un luminophore comprennent chacune des zones discrètes contenant un luminophore sur une surface de la structure LED où la première zone contenant un luminophore est configurée pour convertir la lumière émise par le dispositif LED en une lumière ayant une deuxième longueur d'onde de crête et la deuxième zone contenant un luminophore est configurée pour convertir la lumière émise par le dispositif LED en une lumière ayant une troisième longueur d'onde de crête, plus courte que la deuxième longueur d'onde de crête, et où les premières et deuxièmes zones discrètes contenant un luminophore sont espacées les unes des autres sur la surface de la structure LED ; et
de former un matériau intermédiaire (115, 170) entre des zones adjacentes parmi les premières et deuxièmes zones discrètes espacées contenant un luminophore, **caractérisé en ce que** le matériau intermédiaire a un indice de réfraction inférieur à celui des deuxièmes zones discrètes contenant un luminophore, et le matériau intermédiaire a un indice de réfraction supérieur à celui des premières zones discrètes contenant un luminophore.

4. Procédé de la revendication 3, dans lequel les deuxièmes zones discrètes contenant un luminophore comprennent un luminophore vert/jaune et les premières zones discrètes contenant un luminophore comprennent un luminophore rouge.
